# EUROPÄISCHE PATENTSCHRIFT

(11) **EP 3 583 695 B1**
(45) Veröffentlichungstag und Bekanntmachung des Hinweises auf die Patenterteilung: **11.05.2022**
(21) Anmeldenummer: 18714159.3
(22) Anmeldetag: 13.03.2018
(51) Int. Cl.: H03K 17/687, H02M 1/32, H03K 17/082

(54) **VERFAHREN ZUM STEUERN EINES GLEICHSTROMSCHALTERS, GLEICHSTROMSCHALTER UND GLEICHSPANNUNGSSYSTEM**
METHOD FOR CONTROLLING A DC SWITCH, DC SWITCH AND DC SYSTEM
PROCÉDÉ DE COMMANDE D'UN COMMUTATEUR À COURANT CONTINU, COMMUTATEUR À COURANT CONTINU ET SYSTÈME DE TENSION CONTINUE

(30) Priorität: 23.03.2017 EP 17162606
(43) Veröffentlichungstag der Anmeldung: 25.12.2019
(73) Patentinhaber: Siemens Aktiengesellschaft, 80333 München (DE)
(72) Erfinder: KALUZA, Peter, 92286 Rieden (DE); SCHIERLING, Hubert, 91052 Erlangen (DE); WEIS, Benno, 91334 Hemhofen (DE)
(86) Internationale Anmeldenummer: PCT/EP2018/056173
(87) Internationale Veröffentlichungsnummer: WO 2018/172134

(56) Entgegenhaltungen:
- DE-A1-102013 009 991
- DE-A1-102016 100 776
- US-A- 5 635 821
- US-A1- 2012 235 661

## Beschreibung

Die Erfindung betrifft ein Verfahren zur Steuerung eines Gleichstromschalters. Weiter betrifft die Erfindung einen Gleichstromschalter und ein Gleichspannungssystem.

Um einen Gleichstrom schalten zu können, werden Gleichstromschalter benötigt. Im Gegensatz zum Schalten von Wechselstromschaltern sind diese deutlich komplexer aufgebaut, da im Gleichstrombetrieb, wie er beispielsweise in Gleichspannungsnetzen herrscht, der Strom keinen Nulldurchgang hat, an dem ein Verlöschen des Stromes auf einfache Weise realisiert werden kann.

Derzeit am Markt befindliche Gleichstromschalter sind daher vergleichsweise teuer. Zudem sind diese oftmals nicht kurzschlussfest. Aufgrund ihrer Arbeitsweise sind sie zudem groß und schwer und somit nur unter großem Aufwand in Energieversorgungssysteme oder Antriebssysteme integrierbar. Die Druckschrift DE 10 2013 009991 A1 offenbart ein Verfahren zur Steuerung eines Gleichstromschalters, das dem Oberbegriff des Anspruchs 1 entspricht.

Ein Schutzschalter dient zum Abschalten von elektrischen Stromkreisen, Leitern oder einzelnen Verbrauchern bei Überschreiten der zulässigen Strom- oder Spannungswerte. Dies betrifft beispielsweise sowohl einen Überstrom als auch einen Fehlerstrom. Ein Fehlerstromschalter ist ein Schalter, der öffnet, wenn sich ein Hin- und ein Rückstrom um einen festgelegten Betrag unterscheiden.

Der Erfindung liegt die Aufgabe zugrunde, einen Gleichstromschalter und dessen Steuerung zu verbessern.

Diese Aufgabe wird durch ein Verfahren zur Steuerung eines Gleichstromschalters gelöst, wobei der Gleichstromschalter einen ersten abschaltbaren Halbleiterschalter und einen zweiten abschaltbaren Halbleiterschalter aufweist, wobei der erste und der zweite abschaltbare Halbleiterschalter derart zwischen einem ersten Anschluss und einem zweiten Anschluss angeordnet sind, dass ein Strom mit einer ersten Polarität durch den ersten abschaltbaren Halbleiterschalter führbar ist und der Strom mit einer gegenüber der ersten Polarität entgegengesetzten Polarität durch den zweiten abschaltbaren Halbleiterschalter führbar ist, wobei in Abhängigkeit eines Strommesswertes einer der abschaltbaren Halbleiterschalter abgeschaltet wird, wobei genau einer der abschaltbaren Halbleiterschalter abgeschaltet wird, wobei die Auswahl des abzuschaltenden abschaltbaren Halbleiterschalters in Abhängigkeit von der Polarität des Strommesswertes des Stroms erfolgt. Ferner wird die Aufgabe durch einen Gleichstromschalter mit den Merkmalen des Anspruchs 11 gelöst. Weiter wird die Aufgabe durch ein Gleichspannungssystem mit den Merkmalen des Anspruchs 17 gelöst.

Weitere vorteilhafte Ausgestaltungen der Erfindung sind in den abhängigen Ansprüchen angegeben.

Der Erfindung liegt die Erkenntnis zugrunde, dass ein mechanischer DC Schalter durch einen elektronischen Schalter substituiert wird, vorzugsweise einen Transistor. Da dieser einen Strom abschalten muss, kommt ein abschaltbarer Halbleiterschalter zum Einsatz. Falls die Strom- und/oder Spannungsrichtung sich umkehrt, beispielsweise im Fall einer Rekuperation, ist der abschaltbare Halbleiter häufig mit einer antiparallelen Diode versehen, die dann den Strom in Gegenrichtung leitet. In diesem Fall kann der Strom nur dann unabhängig von seiner Stromflussrichtung, auch als Polarität bezeichnet, abgeschaltet werden wenn ein zweiter abschaltbarer Halbleiterschalter antiseriell zum ersten Schalter eingesetzt wird. Antiseriell heißt in diesem Zusammenhang, dass der zweite abschaltbare Halbleiterschalter in Reihe zum ersten abschaltbaren Halbleiterschalter angeordnet ist, allerdings einen Strom in die andere Richtung, d.h. in entgegengesetzter Polarität führen kann. Auch dieser wird mit einer Invers Diode betrieben, um einen Betrieb des Gleichstromschalters für beide Polaritäten zu ermöglichen. Alternativ können auch rückwärtssperrende IBGTs in Antiparallelschaltung eingesetzt werden. Dabei sind die beiden rückwärtssperrenden IBGTs in einer Parallelschaltung angeordnet und so ausgerichtet, dass der erste abschaltbare Halbleiterschalter den Strom mit einer ersten Polarität führen kann und der zweite abschaltbare Halbleiterschalter den Strom mit entgegengesetzter Polarität führen kann. Neben rückwärtssperrenden IGBTs können auch andere beliebige rückwärtssperrende abschaltbare Halbleiterschalter in einer Antiparallelschaltung angeordnet werden.

Alternativ hat es sich als vorteilhaft bei der antiseriellen Anordnung erwiesen, wenn die antiparallele Diode in den Chip des Transistors integriert ist. Ein solcher Schalter wird auch als rückwärtsleitender Schalter bezeichnet. Weiter ist es möglich, im Fall eines MOSFET oder JFET den Kanal in beide Stromrichtungen zu betreiben (antiparallele Anordnung).

Mit dieser Schalteranordnung ist es möglich, neben Wechselströmen auch Gleichströme zu schalten. Ein besonderer Vorteil besteht darin, dass sich im Gegensatz zu mechanischen Schaltern kein Lichtbogen innerhalb des Schalters bilden kann, der gelöscht, d.h. beseitigt, werden muss. Dabei bietet der erfindungsgemäße Gleichstromschalter zusätzlich die Möglichkeit, den Strom in nur eine Richtung zu unterbrechen. Dazu wird dann genau einer der abschaltbaren Halbleiterschalter abgeschaltet. Somit kann ein elektrischer Verbraucher für die Energieaufnahme vom Netz getrennt werden, beispielsweise wenn dadurch eine Überlastung droht. Gleichzeitig kann ein Rückspeisen von Energie, beispielsweise eines Antriebs, noch ermöglicht werden, da sich dabei die Stromrichtung umdreht, d.h. die Polarität des Stroms sich ändert. Somit kann der elektrische Verbraucher gespeicherte Energie weiterhin abgeben, selbst wenn die Aufnahme von Energie mittels des Gleichstromschalters unterbrochen wurde. Dies ist aufgrund der zwei abschaltbaren Halbleiterschalter möglich.

Die weiterhin mögliche Energierückspeisung erhöht die Umweltverträglichkeit des Systems und hilft (Energie-)Kosten zu senken. Darüber hinaus können gefährliche Zustände beispielsweise für die Wartung vermieden werden, da ein Entladen der im elektrischen Verbraucher befindlichen Energiespeicher mit diesem Gleichstromschalter weiter möglich ist. Somit kann der Energiespeicher vor Beginn von Wartungsarbeiten vollständig oder zumindest nahezu vollständig entladen werden.

Bei Wechselspannungsnetzen (einphasig oder mehrphasig) werden Verbraucher häufig mit Schaltern (= Schützen) ein- und ausgeschaltet. Wird ein Reparaturschalter (= Lasttrennschalter) gefordert, kann er anstelle des Schalters eingesetzt werden. Zum Kurzschluss Schutz wird normalerweise ein Kurzschluss Schaltorgan (= Leistungsschalter) davor eingesetzt. Und zum Leitungsschutz und/oder Kurzschlussschutz des Verbrauchers kann auch eine Schmelzsicherung zum Einsatz kommen. Bei Einsatz des erfindungsgemäßen Gleichstromschalters kann das Konzept bei Wechselspannungsnetzen auf einfache Weise ohne Veränderung auf Gleichstromnetze übertragen werden.

Bei einer vorteilhaften Ausgestaltung der Erfindung erfolgt die Abschaltung eines der abschaltbaren Halbleiterschalter im Fehlerfall. Sobald ein Fehlerfall erkannt wird, wird der Gleichstromschalter ausgeschaltet. Die Abschaltung kann dabei für nur eine Stromrichtung durch Abschalten genau eines Schalters erfolgen. Alternativ kann die Abschaltung auch für beide Stromrichtungen erfolgen indem beide abschaltbaren Halbleiterschalter abgeschaltet werden. Der Fehlerfall kann beispielsweise durch einen Strom erkannt werden, der oberhalb eines betrieblich zulässigen Wertes liegt. Eine weitere Möglichkeit besteht darin, alternativ oder ergänzend die Anstiegsgeschwindigkeit des Stromes zu untersuchen und bei Überschreiten eines festgelegten Wertes auf einen Fehler zu schließen. Die Anstiegsgeschwindigkeit des Stromes entspricht der zeitlichen Ableitung des Stromes.

Bei einer weiteren vorteilhaften Ausgestaltung der Erfindung erfolgt die Abschaltung eines der abschaltbaren Halbleiterschalter in Abhängigkeit von der zeitlichen Ableitung des Strommesswertes. Bei der Abhängigkeit von der zeitlichen Ableitung des Strommesswertes kann ein Fehlerfall aufgrund eines zu hohen Stromanstiegs erkannt werden. Diese Erkennung bietet den Vorteil, schon vor Erreichen hoher Stromwerte den Gleichstromschalter zu öffnen und eine Belastung durch hohe Ströme sowohl für den Verbraucher als auch für den Gleichstromschalter zu vermeiden. Damit können die abschaltbaren Halbleiterschalter teilweise sogar deutlich kleiner und kostengünstiger dimensioniert werden.

Gemäß der Erfindung erfolgt die Auswahl des abzuschaltenden abschaltbaren Halbleiterschalters in Abhängigkeit von der Polarität des Strommesswertes des Stroms. Dabei hat es sich als vorteilhaft erwiesen, den Fehlerstrom, d.h. den Strom im Fehlerfall, hinsichtlich seiner Polarität zu analysieren. Die Information über die Polarität erfordert nur 1 bit, so dass diese sich besonders einfach übertragen lässt.

Durch das Vorzeichen des erfassten Fehlerstromes oder der Spannung kann die lokale Steuervorrichtung des Schalters bestimmen, ob der Fehler lastseitig oder netzseitig von ihm aufgetreten ist. Dies ist auf einfache Weise anhand der Polarität des Stroms möglich. Je nach Polarität des Stromes, d.h. je nach Richtung des Stromes, wird dann nur der Schalter geöffnet, der in Richtung des Fehlers liegt. Dies erlaubt insbesondere bei einem netzseitigen Fehler, der durch einen Fehler in einer anderen Last oder in der oder einer der Energieversorgungseinrichtungen entstanden sein kann, den unterbrechungsfreien Weiterbetrieb der von dem Gleichstromschalter versorgten Last. Netzseitige und lastseitige Fehler lassen sich anhand der Polarität des Fehlerstromes, d.h. anhand der Polarität des Stromes im Fehlerfall erkennen. Dies kann auf einfache Weise anhand des Vorzeichens des Strommesswertes erkannt werden.

Bei einer weiteren vorteilhaften Ausgestaltung der Erfindung erfolgt die Abschaltung bei einer ersten Polarität bei einem ersten Grenzwert und bei einer der ersten Polarität entgegengesetzten Polarität bei einem zweiten Grenzwert, wobei der erste Grenzwert betraglich mindestens 25% größer ist, als der zweite Grenzwert. Es hat sich als vorteilhaft erwiesen, wenn die Auslöseschwelle des Gleichstromschalters für netzseitige Fehlerströme höher gelegt wird als die Auslöseschwelle des Schalters für lastseitige Fehlerströme. Ein Unterschied von mindestens 25%, insbesondere die Überwachung auf einen 30% höheren Fehlerstrom, bewirkt, dass bei einem Fehler in einer Last bevorzugt der direkt vorgelagerte Schalter, das heißt der Gleichstromschalter an dem dazugehörigen Verbraucher, auslöst, was eine natürliche und gewünschte Selektivität zur Folge hat.

Bei einer weiteren vorteilhaften Ausgestaltung der Erfindung wird ein Kurzschluss mittels einer U_{CE}-Überwachung erkannt und wird durch die lokale Steuervorrichtung, die zur Ansteuerung des ersten und des zweiten abschaltbaren Halbleiterschalters vorgesehen ist, insbesondere unabhängig von einer übergeordneten Steuerung, abgeschaltet. Der Gleichstromschalter mit seinen antiparallelen abschaltbaren Halbleiterschaltern wird mit einer bereits aus Wechselrichterschaltungen bekannten U_{CE}-Überwachung kombiniert, die im Falle eines Kurzschlussstromes diesen im Bereich von wenigen µs selbsttätig, ohne dass eine übergeordnete Steuerung vorhanden sein muss, abschalten kann. Die U_{CE}-Überwachung wirkt dabei auf den abschaltbaren Halbleiterschalter des Gleichstromschalters, an dem ein vorgegebener Spannungspegel überschritten wurde. Dies erlaubt insbesondere bei einem netzseitigen Fehler, der durch einen Fehler in einer anderen Last oder in der Energiequelle entstanden sein kann, den unterbrechungsfreien Weiterbetrieb der von dem Schalter versorgten Last.

Bei einer weiteren vorteilhaften Ausgestaltung der Erfindung wird die Belastung des jeweiligen abschaltbaren Halbleiterschalters durch Bildung eines i*t-Wertes oder i²*t-Wertes ermittelt, wobei bei Überschreitung eines Belastungsgrenzwertes der jeweilige abschaltbare Halbleiterschalter abgeschaltet wird. Die abschaltbaren Halbleiterschalter des Gleichstromschalters werden jeweils mit einer Strommessung ausgestattet, die damit in der Lage ist, langsam ansteigende und/oder dauerhaft über dem Bemessungswert liegende Ströme zu erfassen und nach einem i*t oder i²*t Modell oder nach einem anderen Algorithmus zur Bestimmung der Halbleiterbelastung einen evtl. Überstrom abzuschalten, der eine unzulässige Belastung, insbesondere eine unzulässig hohe thermische Belastung des Halbleiters und der Zuleitungen darstellen würde. Dadurch können langsam ansteigende Überlasten des Verbrauchers erfasst werden. Die Auswertung kann in der Elektronik des Schalters selbst oder durch die lokale Steuervorrichtung erfolgen. Im ersten Fall ist die Auslöseschwelle einstell- oder parametrierbar. Für den Fall, dass diese Strommessung Kurzschlussströme sehr schnell erkennen kann (vorzugsweise innerhalb von wenigen µs, insbesondere weniger als 10 µs), kann auf eine U_{CE}-Überwachung verzichtet werden.

Bei einer weiteren vorteilhaften Ausgestaltung der Erfindung wird eine Differenz zwischen dem Strommesswert und einem weiteren Strommesswert gebildet, wobei der weitere Strommesswert an einer Stelle erfasst wird, an der ein dem Strommesswert zugehöriger Rückstrom angenommen wird, wobei bei Überschreiten des Betrags der Differenz mindestens einer der abschaltbaren Halbleiterschalter abgeschaltet wird. In einem Abzweig zu einem elektrischen Verbraucher, der durch den Gleichstromschalter abgesichert ist, können Schalter für beide DC-Schienen angeordnet werden, die gemeinsam oder getrennt ausgelöst werden. In dieser Anordnung kann die Stromdifferenz in den beiden Schienen ermittelt werden. Die Differenz kann dabei beispielsweise zu Diagnosezwecken an eine überlagerte Steuerung gemeldet werden. So lässt sich auf einfache Weise ein Fehlerstromschutz realisieren, ohne dass weitere Elemente wie beispielsweise ein FI-Schutzschalter benötigt wird.

Bei einer weiteren vorteilhaften Ausgestaltung der Erfindung wird die Differenz frequenzselektiv, insbesondere für Frequenzen unterhalb 1 kHz, gebildet. Es hat sich als vorteilhaft erwiesen, wenn die lokale Steuervorrichtung beide abschaltbaren Halbleiterschalter öffnet, wenn die Differenz eine vorgegebene Schwelle von beispielsweise 300 mA überschreitet. Die Messung der Differenz kann im Frequenzbereich eingeschränkt sein, beispielsweise auf Frequenzen unter 1 kHz, um ein Fehlansprechen des Gleichstromschalters zu verhindern.

Bei einer weiteren vorteilhaften Ausgestaltung der Erfindung weist der Gleichstromschalter einen Komparator zur Erkennung der Polarität des Stroms aufweist. Mit einem Komparator lässt sich auf einfache Weise ermitteln, ob der Strom eine positive oder negative Polarität hat. D.h. man kann mittels des Komparators die Stromrichtung erkennen, indem man untersucht ob der Strom einen Wert größer oder kleiner als null hat. Der Komparator ist ein zuverlässiges Bauteil der sich insbesondere für den Einsatz in sicherheitsrelevanten Anwendungen eignet. Im Gegensatz zu einer softwaregestützten Analyse der Polarität des Stromes ist der Nachweis des zuverlässigen Verhaltens deutlich einfacher zu erbringen und sicherzustellen.

Bei einer weiteren vorteilhaften Ausgestaltung der Erfindung ist zwischen dem ersten Anschluss und einem der abschaltbaren Halbleiterschalter ein Schutzelement, insbesondere ein Lasttrennschalter und/oder eine Sicherung, angeordnet. Falls doch einmal, beispielsweise durch unzulässig hohe Spannungsspitzen am Gleichstromschalter, insbesondere an den abschaltbaren elektronischen Halbleiterschaltern, dieser nicht rechtzeitig abschalten kann oder beim Abschalten versagt und ein Kurzschlussstrom trotzdem sicher abgeschaltet werden soll, wird vor den Gleichstromschalter ein Sicherungselement, auch als Schutzelement bezeichnet, vorgeschaltet. Bei dem Schutzelement kann es sich in einer einfachen Ausführung um eine Sicherung wie eine Schmelzsicherung oder eine Sprengsicherung handeln. Das Ansprechen der Sicherung kann durch die lokale Steuervorrichtung des Gleichstromschalters ausgewertet und an eine übergeordnete Steuerung gemeldet werden.

Zusätzlich oder alternativ kann ein Lasttrennschalter als Reparaturschalter eingebaut werden, der sicherstellt, dass in AUS-Stellung Reparaturarbeiten am elektrischen Verbraucher durchgeführt werden können. Falls der Reparaturschalter betätigt wird, obwohl der elektronische Schalter noch eingeschaltet ist, kann durch Erfassen und Auswerten der hochfrequenten Anteile der Spannungs- und Stromsignale das Vorhandensein eines Lichtbogens, sowohl im Lasttrennschalter als auch im elektrischen Verbraucher, erkannt werden und dann mit einem der abschaltbaren Halbleiterschalter des Gleichstromschalters abgeschaltet werden. Dazu kann die gleiche Strommessvorrichtung verwendet werden, wie sie auch für das Erkennen der Polarität des Fehlerstroms verwendet wird. Somit ist dieses Verfahren besonders kostengünstig, da kein weiterer Hardwarebedarf für die Strommessung entsteht.

Die übergeordnete Steuerung kann z.B. über einen BUS den Gleichstromschalter einschalten und ausschalten. Ebenso kann der Zustand des elektronischen Schalters (ein, aus, ausgelöst, etc.) gemeldet werde. Ferner wird die Höhe der Spannungen und/oder die Höhe des Stromes erfasst und ausgewertet: bei der Erfassung der Höhe der Spannungen und/oder der Ströme an den einzelnen seriellen Schaltern kann bestimmt werden, wo eine Überlast oder ein Kurzschluss aufgetreten ist und dann selektiv abgeschaltet werden. Dabei wird in vorteilhafter Weise nur in der Richtung abgeschaltet, wo der Fehler aufgetreten ist.

Bei einer weiteren vorteilhaften Ausgestaltung der Erfindung weist die lokale Steuervorrichtung eine Schnittstelle zu einer übergeordneten Steuerung auf, wobei mittels der übergeordneten Steuerung die abschaltbaren Halbleiterschalter zu- und abschaltbar sind. Dabei kann mindestens ein Spannungswert oder Stromwert des Gleichstromschalters an eine übergeordnete Steuerung, vorzugsweise potentialfrei, über einen BUS weiter geleitet werden. Diese Spannungsmessung eröffnet die Möglichkeit, dass Selektivität sichergestellt werden kann, um einen Fehler zuverlässig zu erkennen und zu charakterisieren und seinen Fehlerort zu bestimmen. Dabei weist im einfachsten Fall diese übertragene Information nur 1 bit (|U| > Umax) oder 2 bit (U < -Umax oder U > Umax) auf. Alternativ oder ergänzend kann die Selektivität durch Einstellen von Strom-/Zeitkennlinien in der Elektronik des Schalters erzeugt werden.

Im Folgenden wird die Erfindung anhand der in den Figuren dargestellten Ausführungsbeispiele näher beschrieben und erläutert. Es zeigen:
FIG 1 ein Gleichstromschalter, verbunden mit einem elektrischen Verbraucher und einer Energiequelle und
FIG 2 ein Energieversorgungssystem

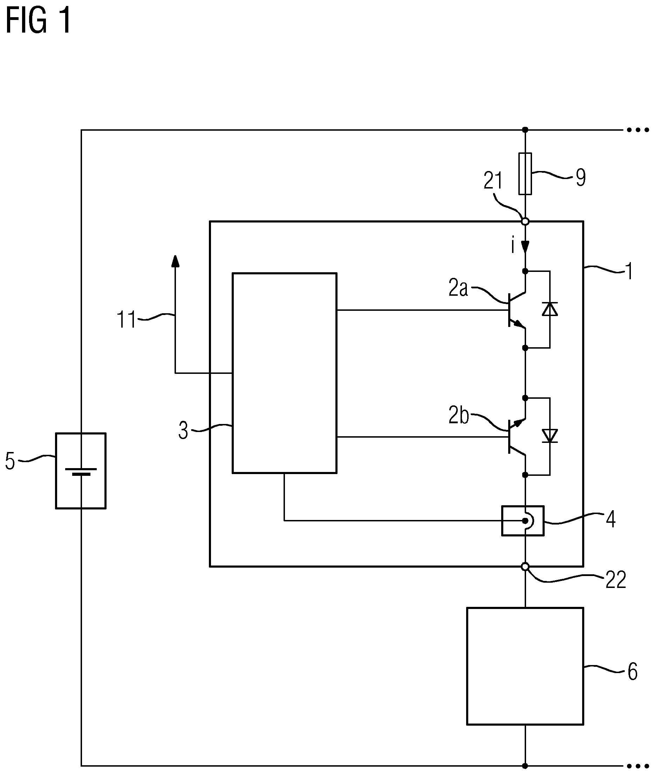

Die FIG 1 zeigt einen Gleichstromschalter 1, der mit einer Energiequelle 5 und einem elektrischen Verbraucher 6 verbunden ist. Bei der Energiequelle 5 kann es sich um einen Generator, Photovoltaikanlage, ein Energieversorgungsnetz oder auch um einen Energiespeicher, wie beispielsweise eine Batterie handeln. Der Gleichstromschalter 1 dient dazu, den elektrischen Verbraucher 6 von der Energiequelle 5 zu trennen und einen Strom i abzuschalten. Zur Messung des Stromes i dient eine Strommessvorrichtung 4, die innerhalb des Gleichstromschalters 1 oder außerhalb des Gleichstromschalters 1 angeordnet sein kann. Zwischen dem ersten Anschluss 21 des Gleichstromschalters 1 und dem zweiten Anschluss 22 sind die abschaltbaren Halbleiterschalter 2a, 2b antiseriell angeordnet. Das bedeutet, dass ein Stromfluss durch den ersten Halbleiterschalter 2a durch die zum zweiten Halbleiterschalter 2b antiparalleler Diode fließt. Bei entgegengesetzter Polarität, d.h. bei umgekehrter Stromflussrichtung fließt der Strom durch den zweiten Halbleiterschalter 2b und durch die zum ersten Halbleiterschalter 2a antiparallele Diode. Eine Antiparallele Schaltung der beiden Halbleiterschalter 2a, 2b ist hier nicht dargestellt. In diesem Fall kann auf Dioden verzichtet werden, jedoch müssen die Halbleiterschalter dann rückwärts sperrfähig sein.

Zur Ansteuerung der Halbleiterschalter 2a, 2b dient die lokale Steuervorrichtung 3, die mit den Steueranschlüssen der Halbleiterschalter 2a, 2b verbunden ist. Die Steuerlogik bzw. Regelungslogik verwendet dabei als Eingangsgröße das Signal der Strommessvorrichtung 4. Zur Verbindung mit einer hier nicht dargestellten übergeordneten Steuerung 8 dient die Schnittstelle 11 zu der übergeordneten Steuerung 8.

Als weiteres Schutzelement kann in den Verbraucherabzweig eine Sicherung 9 integriert werden, die bei einer hohen Strombelastung unabhängig von dem Gleichstromschalter 1, insbesondere unabhängig von der lokalen Steuervorrichtung 3, den Schutz des elektrischen Verbrauchers 6 gewährleistet.

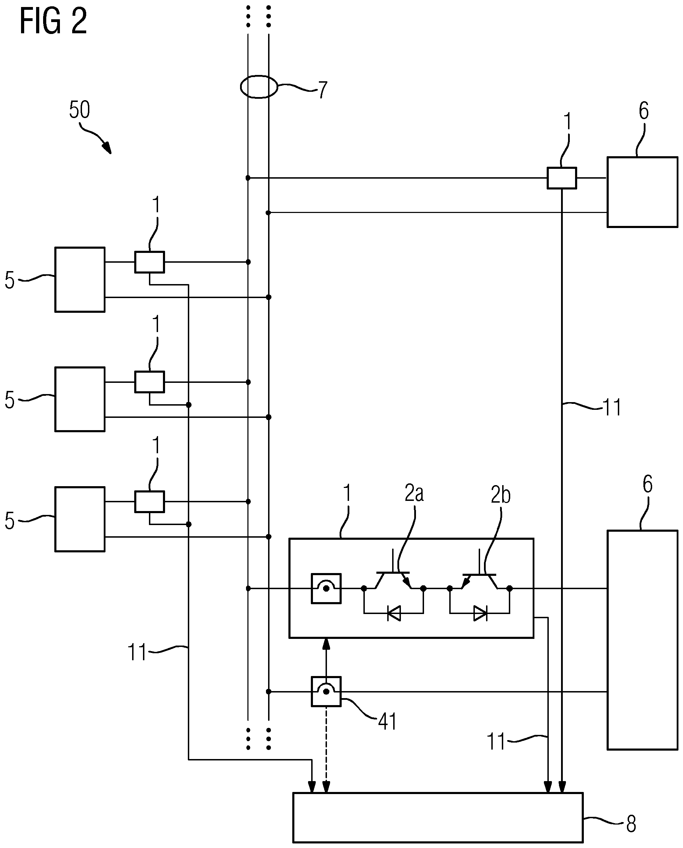

Die FIG 2 zeigt ein Gleichspannungssystem 50, das eine Vielzahl von Energiequellen 5 und elektrischen Verbrauchern 6 aufweist. Zur Vermeidung von Wiederholungen wird auf die Beschreibung zur FIG 1 und auf die dort eingeführten Bezugszeichen verwiesen. Diese Komponenten sind über eine Sammelschiene 7 miteinander verbunden. Die Sammelschiene 7 umfasst dabei einen Hinleiter und einen Rückleiter, der dem Strom zum elektrischen Verbraucher 6 (Hinleiter) und wieder zurück (Rückleiter) zur Energiequelle 5 dient. Die einzelnen Energiequellen 5 sowie die elektrischen Verbraucher 6 sind jeweils über einen oder, hier nicht dargestellt, mehrere Gleichstromschalter 1 mit der Sammelschiene 7 trennbar verbunden. Die Energieübertragung innerhalb des Gleichspannungssystems zwischen den Komponenten erfolgt mittels Gleichspannung auf der Sammelschiene 7. Dabei liegt zwischen den beiden Leitern eine Gleichspannung an.

An dem unteren elektrischen Verbraucher soll die Möglichkeit eines Fehlerstromschutzes näher erläutert werden, so dass einige wesentliche Komponenten des Gleichstromschalters 1 genauer dargestellt sind. Um einen Fehlerstromschutz herzustellen, ist eine weitere Strommessvorrichtung 41 in dem entsprechenden Verbraucherpfad vorhanden. In einem der beiden Leitern der Sammelschiene 7 ist die Strommessvorrichtung 4 angeordnet und in dem anderen Leiter die entsprechende weitere Strommessvorrichtung 41. Somit sind der Hinstrom zum elektrischen Verbraucher 6 und der Rückstrom von diesem elektrischen Verbraucher 6 messbar. Für den Fall, dass diese Ströme nicht identisch sind, d.h. die Differenz ist ungleich null, kann davon ausgegangen werden, dass ein Fehlerstrom vorhanden ist und der Gleichstromschalter öffnet seine Verbindung mittels zumindest einem der beiden abschaltbaren Halbleiterschaltern 2a,2b. Dazu kann die weitere Strommessvorrichtung 41 das Messsignal an den Gleichstromschalter 1 übermitteln. Die hier nicht dargestellte lokale Steuervorrichtung 3 wertet dieses Signal beispielsweise durch Differenzbildung mit dem Signal der Strommessvorrichtung 4 aus und leitet bei Bedarf die Schutzreaktion ein, indem sie über die Ansteuerung mindestens eines der abschaltbaren Halbleiterschalter 2a, 2b diesen Halbleiterschalter in den sperrenden Zustand versetzt.

Ebenso ist es möglich, den Fehlerstromschutz durch eine übergeordnete Steuerung 8 durchzuführen. In diesem Fall wird neben dem Signal der Strommessvorrichtung 4, die beispielsweise über eine entsprechende Schnittstelle 11 erfolgt, auch das Signal der weiteren Strommessvorrichtung 41 an die übergeordnete Steuerung 8 übertragen. Die übergeordnete Steuerung 8 kann darüber hinaus aus den Signalen der einzelnen Gleichstromschalter 1 den Betriebszustand der einzelnen Komponenten (Energiequellen 5 und elektrische Verbraucher 6) überwachen und bei Bedarf einen einzelnen oder mehrere Gleichspannungsschalter 1 ansteuern. Ebenso ist es möglich, aus diesen Informationen über den Zustand der einzelnen Komponenten im Gleichstromsystem 50 zu ermitteln.

## Patentansprüche

1. Verfahren zur Steuerung eines Gleichstromschalters (1), insbesondere eines Fehlerstromschalters oder eines Schutzschalters, wobei der Gleichstromschalter (1) einen ersten abschaltbaren Halbleiterschalter (2a) und einen zweiten abschaltbaren Halbleiterschalter (2b) aufweist, wobei der erste und der zweite abschaltbare Halbleiterschalter (2a,2b) derart zwischen einem ersten Anschluss (21) und einem zweiten Anschluss (22) angeordnet sind, dass ein Strom (i) mit einer ersten Polarität durch den ersten abschaltbaren Halbleiterschalter (2a) führbar ist und der Strom (i) mit einer gegenüber der ersten Polarität entgegengesetzten Polarität durch den zweiten abschaltbaren Halbleiterschalter (2b) führbar ist, wobei in Abhängigkeit eines Strommesswertes einer der abschaltbaren Halbleiterschalter (2a,2b) abgeschaltet wird,
**dadurch gekennzeichnet, dass**
genau einer der abschaltbaren Halbleiterschalter (2a,2b) abgeschaltet wird, wobei die Auswahl des abzuschaltenden abschaltbaren Halbleiterschalters (2a,2b) in Abhängigkeit von der Polarität des Strommesswertes des Stroms (i) erfolgt.

2. Verfahren nach Anspruch 1, wobei der erste abschaltbare Halbleiterschalter (2a) und der zweite abschaltbare Halbleiterschalter (2b) antiseriell angeordnet sind.

3. Verfahren nach Anspruch 1, wobei der erste abschaltbare Halbleiterschalter (2a), insbesondere ausgebildet als ein rückwärtssperrender IGBT, und der zweite abschaltbare Halbleiterschalter (2b), insbesondere ausgebildet als ein rückwärtssperrender IGBT, in einer Antiparallelschaltung angeordnet sind.

4. Verfahren nach einem der Ansprüche 1 bis 3, wobei die Abschaltung eines der abschaltbaren Halbleiterschalter (2a,2b) im Fehlerfall erfolgt.

5. Verfahren nach Anspruch 4, wobei die Abschaltung eines der abschaltbaren Halbleiterschalter (2a,2b) in Abhängigkeit von der zeitlichen Ableitung des Strommesswertes erfolgt.

6. Verfahren nach einem der Ansprüche 1 bis 5, wobei die Abschaltung bei einer ersten Polarität bei einem ersten Grenzwert erfolgt und bei einer der ersten Polarität entgegengesetzten Polarität bei einem zweiten Grenzwert erfolgt, wobei der erste Grenzwert betraglich mindestens 25% größer ist als der zweite Grenzwert.

7. Verfahren nach einem der Ansprüche 1 bis 6, wobei ein Kurzschluss mittels einer U_{CE}-Überwachung erkannt wird und durch die lokale Steuervorrichtung (3), die zur Ansteuerung des ersten und des zweiten abschaltbaren Halbleiterschalters (2a,2b) vorgesehen ist, insbesondere unabhängig von einer übergeordneten Steuerung (8), abgeschaltet wird.

8. Verfahren nach einem der Ansprüche 1 bis 7, wobei die Belastung des jeweiligen abschaltbaren Halbleiterschalters (2a,2b) durch Bildung eines i*t-Wertes oder i²*t-Wertes ermittelt wird, wobei bei Überschreitung eines Belastungsgrenzwertes der jeweilige abschaltbare Halbleiterschalter (2a,2b) abgeschaltet wird.

9. Verfahren nach einem der Ansprüche 1 bis 8, wobei eine Differenz zwischen dem Strommesswert und einem weiteren Strommesswert gebildet wird, wobei der weitere Strommesswert an einer Stelle erfasst wird, an der ein dem Strommesswert zugehöriger Rückstrom angenommen wird, wobei bei Überschreiten des Betrags der Differenz mindestens einer der abschaltbaren Halbleiterschalter (2a,2b) abgeschaltet wird.

10. Verfahren nach Anspruch 9, wobei die Differenz frequenzselektiv, insbesondere für Frequenzen unterhalb 1 kHz, gebildet wird.

11. Gleichstromschalter (1) aufweisend
- einen ersten und einen zweiten abschaltbaren Halbleiterschalter (2a,2b)
- eine lokale Steuervorrichtung (3) zur Durchführung des Verfahrens nach einem der Ansprüche 1 bis 10,
wobei der erste und der zweite abschaltbare Halbleiterschalter (2a,2b) derart zwischen einem ersten Anschluss (21) und einem zweiten Anschluss (22) angeordnet sind, dass ein Strom (i) mit einer ersten Polarität durch den ersten abschaltbaren Halbleiterschalter (2a) führbar ist und der Strom (i) mit einer gegenüber der ersten Polarität entgegengesetzten Polarität durch den zweiten abschaltbaren Halbleiterschalter (2b) führbar ist, wobei die lokale Steuervorrichtung (3) dazu eingerichtet ist, den Strom (i) durch den Gleichstromschalter (1) in Abhängigkeit eines Strommesswertes durch Abschalten genau eines der abschaltbaren Halbleiterschalter (2a,2b) abzuschalten und die Auswahl des abzuschaltenden abschaltbaren Halbleiterschalters (2a,2b) in Abhängigkeit von der Polarität des Strommesswertes des Stroms (i) erfolgt.

12. Gleichstromschalter (1) nach Anspruch 11, wobei der Gleichstromschalter einen Komparator zur Erkennung der Polarität des Stroms (i) aufweist.

13. Gleichstromschalter (1) nach einem der Ansprüche 11 oder 12, wobei der erste und der zweite abschaltbare Halbleiterschalter (2a,2b) jeweils eine U_{CE}-Überwachung aufweisen.

14. Gleichstromschalter (1) nach einem der Ansprüche 11 bis 13, wobei zwischen dem ersten Anschluss (21) und einem der abschaltbaren Halbleiterschalter ein Schutzelement, insbesondere ein Lasttrennschalter und/oder eine Sicherung (9), angeordnet ist.

15. Gleichstromschalter (1) nach einem der Ansprüche 11 bis 14, wobei der Gleichstromschalter (1) eine Strommessvorrichtung (4) und/oder eine Spannungsmessvorrichtung (42) aufweist.

16. Gleichstromschalter (1) nach einem der Ansprüche 11 bis 15 wobei die lokale Steuervorrichtung (3) eine Schnittstelle (11) zu einer übergeordneten Steuerung (8) aufweist, wobei mittels der übergeordneten Steuerung (8) die abschaltbaren Halbleiterschalter (2a,2b) zu- und abschaltbar sind.

17. Gleichspannungssystem (50) umfassend
- mindestens eine Energiequelle (5) mit einer Gleichspannung
- mindestens ein elektrischer Verbraucher (6) mit einem Gleichspannungsanschluss
- mindestens ein Gleichstromschalter (1) nach einem der Ansprüche 11 bis 16.

## Claims

1. Method for controlling a direct current switch (1), in particular a fault current switch or a circuit-breaker, wherein the direct current switch (1) has a first semiconductor switch (2a) which can be switched off and a second semiconductor switch (2b) which can be switched off, wherein the first and the second semiconductor switches (2a, 2b) which can be switched off are arranged between a first terminal (21) and a second terminal (22) such that a current (i) with a first polarity can be conducted through the first semiconductor switch (2a) which can be switched off and the current (i) with a polarity that is opposite to the first polarity can be conducted through the second semiconductor switch (2b) which can be switched off, wherein one of the semiconductor switches (2a, 2b) which can be switched off is switched off as a function of a current measurement value, **characterised in that** precisely one of the semiconductor switches (2a, 2b) which can be switched off is switched off, wherein the selection of the semiconductor switch (2a, 2b) which can be switched off to be switched off takes place as a function of the polarity of the current measurement value of the current (i).

2. Method according to claim 1, wherein the first semiconductor switch (2a) which can be switched off and the second semiconductor switch (2b) which can be switched off are arranged antiserially.

3. Method according to claim 1, wherein the first semiconductor switch (2a) which can be switched off, in particular embodied as a reverse-blocking IGBT, and the second semiconductor switch (2b) which can be switched off, in particular embodied as a reverse-blocking IGBT, are arranged in an antiparallel circuit.

4. Method according to one of claims 1 to 3, wherein one of the semiconductor switches (2a, 2b) which can be switched off is switched off in a fault situation.

5. Method according to claim 4, wherein one of the semiconductor switches (2a, 2b) which can be switched off is switched off as a function of the time derivation of the current measurement value.

6. Method according to one of claims 1 to 5, wherein the switch-off takes place at a first limit value in the case of a first polarity and at a second limit value in the case of a polarity opposite to that of the first polarity, wherein the first limit value is at least 25% greater in size than the second limit value.

7. Method according to one of claims 1 to 6, wherein a short circuit is detected by means of U_{CE} monitoring and is switched off, in particular independently of a superordinate controller (8), by the local control device (3), which is provided for triggering the first and the second semiconductor switch (2a, 2b) which can be switched off.

8. Method according to one of claims 1 to 7, wherein the load of the respective semiconductor switch (2a, 2b) which can be switched off is determined by formation of an i*t value or i²*t value, wherein the respective semiconductor switch (2a, 2b) which can be switched off is switched off if a load limit value is exceeded.

9. Method according to one of claims 1 to 8, wherein a difference is formed between the current measurement value and a further current measurement value, wherein the further current measurement value is registered at a point at which a return current associated with the current measurement value is assumed, wherein at least one of the semiconductor switches (2a, 2b) which can be switched off is switched off if the amount of the difference is exceeded.

10. Method according to claim 9, wherein the difference is formed frequency-selectively, in particular for frequencies below 1 kHz.

11. Direct current switch (1) having
- a first and a second semiconductor switch (2a, 2b) which can be switched off,
- a local control device (3) for performing the method according to one of claims 1 to 10,
wherein the first and the second semiconductor switches (2a, 2b) which can be switched off are arranged between a first terminal (21) and a second terminal (22) such that a current (i) with a first polarity can be conducted through the first semiconductor switch (2a) which can be switched off and the current (i) with a polarity that is opposite to the first polarity can be conducted through the second semiconductor switch (2b) which can be switched off, wherein the local control device (3) is configured to switch off the current (i) through the direct current switch (1) as a function of a current measurement value by switching off precisely one of the semiconductor switches (2a, 2b) which can be switched off and the selection of the semiconductor switch (2a, 2b) which can be switched off to be switched off takes place as a function of the polarity of the current measurement value of the current (i).

12. Direct current switch (1) according to claim 11, wherein the direct current switch has a comparator for detecting the polarity of the current (i).

13. Direct current switch (1) according to one of claims 11 or 12, wherein the first and the second semiconductor switch (2a, 2b) which can be switched off each have U_{CE} monitoring.

14. Direct current switch (1) according to one of claims 11 to 13, wherein a protection element, in particular a switch-disconnector and/or a fuse (9), is arranged between the first terminal (21) and one of the semiconductor switches which can be switched off.

15. Direct current switch (1) according to one of claims 11 to 14, wherein the direct current switch (1) has a current measurement device (4) and/or a voltage measurement device (42) .

16. Direct current switch (1) according to one of claims 11 to 15, wherein the local control device (3) has an interface (11) to a superordinate controller (8), wherein the semiconductor switches (2a, 2b) which can be switched off can be switched on and off by means of the superordinate controller (8).

17. DC voltage system (50) comprising
- at least one energy source (5) with a DC voltage
- at least one electric load (6) with a DC voltage connection
- at least one direct current switch (1) according to one of claims 11 to 16.

## Revendications

1. Procédé de commande d'un interrupteur (1) à courant continu, notamment d'un interrupteur par courant de défaut ou d'un interrupteur de protection, l'interrupteur (1) à courant continu ayant un premier interrupteur (2a) à semiconducteur pouvant être ouvert et un deuxième interrupteur (2b) à semiconducteur pouvant être ouvert, dans lequel le premier et le deuxième interrupteurs (2a, 2b) à semiconducteur pouvant être ouverts sont montés entre une première borne (21) et une deuxième borne (22), de manière à ce qu'un courant (i) d'une première polarité puisse passer dans le premier interrupteur (2a) à semiconducteur pouvant être ouvert et de manière à ce que le courant (i) d'une polarité opposée à la première polarité puisse passer dans le deuxième interrupteur (2b) à semiconducteur pouvant être ouvert, dans lequel, en fonction d'une valeur de mesure du courant, on ouvre l'un des interrupteurs (2a, 2b) à semiconducteur pouvant être ouvert,
**caractérisé en ce que**
l'on ouvre exactement l'un des interrupteurs (2a, 2b) à semiconducteur pouvant être ouverts, dans lequel on effectue le choix de l'interrupteur (2a, 2b) à semiconducteur pouvant être ouvert à ouvrir, en fonction de la polarité de la valeur de mesure du courant (i).

2. Procédé suivant la revendication 1, dans lequel le premier interrupteur (2a) à semiconducteur pouvant être ouvert et le deuxième interrupteur (2b) à semiconducteur pouvant être ouvert sont montés tête bêche.

3. Procédé suivant la revendication 1, dans lequel le premier interrupteur (2a) à semiconducteur pouvant être ouvert, constitué notamment sous la forme d'un IGBT à blocage inverse, et le deuxième interrupteur (2b) à semiconducteur pouvant être ouvert, constitué notamment sous la forme d'un IGBT à blocage inverse, sont montés dans un circuit tête bêche.

4. Procédé suivant l'une des revendications 1 à 3, dans lequel l'ouverture de l'un des interrupteurs (2a, 2b) à semi-conducteur pouvant être ouvert s'effectue en cas de défaillance.

5. Procédé suivant la revendication 4, dans lequel l'ouverture de l'un des interrupteurs (2a, 2b) à semiconducteur pouvant être ouvert s'effectue en fonction de la dérivée en fonction du temps de la valeur de mesure du courant.

6. Procédé suivant l'une des revendications 1 à 5, dans lequel l'ouverture, à une première polarité, s'effectue à une première valeur limite et s'effectue, à une polarité opposée à la première polarité, à une deuxième valeur limite, la première valeur limite étant en valeur absolue plus grande d'au moins 25% que la deuxième valeur limite.

7. Procédé suivant l'une des revendications 1 à 6, dans lequel on détecte un court-circuit au moyen d'un contrôle d'U_{CE} et on met hors circuit, notamment indépendamment d'une commande (8) supérieure hiérarchiquement, par le dispositif (3) local de commande, qui est prévu pour la commande du premier et du deuxième interrupteurs (2a, 2b) à semiconducteur pouvant être ouverts.

8. Procédé suivant l'une des revendications 1 à 7, dans lequel on détermine la charge de l'interrupteur (2a, 2b) respectif à semiconducteur pouvant être ouvert en formant une valeur i*t ou une valeur i²*t, dans lequel, si une valeur limite de charge est dépassée, on ouvre l'interrupteur (2a, 2b) respectif à semiconducteur pouvant être ouvert.

9. Procédé suivant l'une des revendications 1 à 8, dans lequel on forme une différence entre la valeur de mesure du courant et une autre valeur de mesure du courant, dans lequel on détecte l'autre valeur de mesure du courant en un point où on prend un courant de retour associé à la valeur de mesure du courant, dans lequel, si la valeur absolue de la différence est dépassée, on ouvre au moins l'un des interrupteurs (2a, 2b) à semiconducteur pouvant être ouverts.

10. Procédé suivant la revendication 9, dans lequel on forme la différence sélectivement en fréquence, notamment pour des fréquences en-dessous de 1 kHz.

11. Interrupteur (1) à courant continu comportant
- un premier et un deuxième interrupteurs (2a, 2b) à semiconducteur pouvant être ouverts
- un dispositif (3) local de commande pour effectuer le procédé suivant l'une des revendications 1 à 10,
dans lequel le premier et le deuxième interrupteurs (2a, 2b) à semiconducteur pouvant être ouverts sont montés entre une première borne (21) et une deuxième borne (22), de manière à ce qu'un courant (i) d'une première polarité puisse passer dans le premier interrupteur (2a) à semiconducteur pouvant être ouvert et de manière à ce que le courant (i) de polarité opposée à la première polarité puisse passer dans le deuxième interrupteur (2b) à semiconducteur pouvant être ouvert, dans lequel le dispositif (3) local de commande est conçu pour interrompre le courant (i) par l'interrupteur (1) à courant continu en fonction d'une valeur de mesure du courant, en ouvrant exactement l'un des interrupteurs (2a, 2b) à semiconducteur pouvant être ouverts et le choix de l'interrupteur (2a, 2b) à semiconducteur pouvant être ouvert à ouvrir s'effectue en fonction de la polarité de la valeur de mesure du courant (i).

12. Interrupteur (1) à courant continu suivant la revendication 11, dans lequel l'interrupteur à courant continu a un comparateur de détection de la polarité du courant (i).

13. Interrupteur (1) à courant continu suivant l'une des revendications 11 ou 12, dans lequel le premier et le deuxième interrupteurs (2a, 2b) à semiconducteur pouvant être ouverts ont chacun un contrôle d'U_{CE}.

14. Interrupteur (1) à courant continu suivant l'une des revendications 11 à 13, dans lequel un élément de protection, notamment un sectionneur en charge et/ou un fusible (9) est monté entre la première borne (21) et l'un des interrupteurs à semiconducteur pouvant être ouvert.

15. Interrupteur (1) à courant continu suivant l'une des revendications 11 à 14, dans lequel l'interrupteur (1) à courant continu a un dispositif (4) de mesure du courant et/ou un dispositif (42) de mesure de la tension.

16. Interrupteur (1) à courant continu suivant l'une des revendications 11 à 15, dans lequel le dispositif (3) local de commande a une interface (11) avec une commande (8) supérieure hiérarchiquement, dans lequel les interrupteurs (2a, 2b) à semiconducteur pouvant être ouverts peuvent être fermés et ouverts au moyen de la commande (8) supérieure hiérarchiquement.

17. Système (50) à tension continue comprenant
- au moins une source (5) d'énergie ayant une tension continue
- au moins un consommateur (6) électrique ayant une borne de tension continue
- au moins un interrupteur (1) à courant continu suivant l'une des revendications 11 à 16.
